# EUROPEAN PATENT APPLICATION

(11) **EP 2 878 755 A1**
(43) Date of publication of application: **03.06.2015**
(21) Application number: 14195715.9
(22) Date of filing: 01.12.2014
(51) Int. Cl.: E06B 7/18, E06B 5/20, H05K 9/00

(54) **Manual-automatic rf sealing system**

(30) Priority: 29.11.2013 US 201361910222 P
(71) Applicant: ETS Lingren, Inc, Wood Dale, IL 60191-1075 (US)
(72) Inventor: Kolobayev, Paul V, Buffalo Grove, IL Illinois 60089 (US); Reese, David P, Arlington Heights, IL Illinois 60004 (US); Hamouz, Michael G, Streamwood, IL Illinois 60107 (US); Gugis, Saulius, Naperville, IL Illinois 60565-3020 (US); Weibler, Joseph C, West Chicago, IL Illinois 60185 (US); Kilgore, Steven T, South Elgin, IL Illinois 60177 (US)
(74) Representative: Serjeants LLP

(57) **Abstract**

A modular system (10) to attenuate radio frequency encroachment and acoustic noise into an enclosure is described. The system uses a door leaf (12), a jamb (14) for the leaf, and acoustic and RF seals removably positioned on the jamb, or on the door, or both. The jamb can include radio frequency, radiation, and acoustic attenuation seals.

## Description

### PRIORITY

This Utility Patent Application claims the benefits of U.S. Provisional Patent Application No. 61/910,222, filed on November 29, 2013.

### BACKGROUND OF THE INVENTION

### 1. Field of the Invention.

This invention relates to a radio frequency (RF) seal and more specifically, this invention relates to a manual and an automatic system for creating RF and acoustic seals.

### 2. Background of the Invention.

Electromagnetic radiation permeates the environment. Most of the time this radiation exists unnoticed. However, situations requiring exclusion of this ubiquitous radiation continue to proliferate. For example, production environments for electronics require RF-noise free areas for testing and QA efforts. In medical environments, magnetic resonance images provided by MRI operations are distorted by RF which emanate from nearby elevator motors, cell phones, and even passing vehicles

MRI enclosures require doors which on the one hand must freely allow passage of patients and gurneys to the MRI enclosure, and on the other hand must seal off the enclosure from encroachment from electromagnetic radiation. State of the art MRI doors and windows are heavy or complex, or both. In the case of automatic door sealing mechanisms, compressed air or electricity needs to be available to assure door operation. In the event of a power loss, the doors must be designed to default to an open configuration to assure ingress or egress to or from the enclosure.

In the case of manual door sealing mechanisms, considerable force is required to move the door and actuate a friction-induced seal between the door and the jamb of the enclosure. Metal to metal contact is required to create a good RF seal with manually actuated doors. But the friction required to create this seal has necessitated the use of cam-action heavy-duty handle mechanisms for high performance doors. Also, state of the art systems have become bulky when more than one type of attenuation is desired, for example when an access door must attenuate RF radiation, low level medical isotopic radiation, and/or acoustical noise.

A need exists in the art for an architectural door or hatchway for attenuating RF radiation in a myriad of environments, including medical and nonmedical. The door should be both manually and automatically operated. The door needs to be ADA compliant such that it is easy to operate. The system also needs to accommodate a flat threshold of an MRI enclosure. Finally, the system should enable the attenuation of different kinds of frequencies within existing trim sizes, and at a reasonable cost.

### SUMMARY OF INVENTION

An object of the invention is to provide a system for effecting RF seals that overcomes many of the disadvantages of the prior art.

Another object of the invention is to provide a system for manually or automatically effectuating an RF- and/or acoustic- seal. A feature of the invention is that it is adapted to accommodate a myriad of different seal types. In an embodiment of the invention, an RF seal is located on a door jamb and not the door leaf to minimize any seal damage. In another embodiment, a mesh gasket is mechanically fastened to the door. An advantage of the invention is that it can cater to different RF and sound attenuation requirements.

Still another object of the present invention is to provide a system for simultaneous activation and deactivation of RF attenuation and sound attenuation features in an MRI enclosure door. A feature of the invention is that the RF and sound attenuation and deactivation occurs without the need for electrical power. An advantage of the system is that it provides an automatic attenuation feature when solely human power is used to open and close the door.

Briefly, the invention provides a system to attenuate radio frequency encroachment and acoustic noise into an enclosure, the system comprising a door leaf; and a jamb adapted to receive the leaf; and a plurality of acoustic and RF seals removably positioned on the jamb, or on the door, or both. The jamb is adapted to receive a plurality of radiation and acoustic attenuation seals.

### BRIEF DESCRIPTION OF THE DRAWING

The invention together with the above and other objects and advantages will be best understood from the following detailed description of the preferred embodiment of the invention shown in the accompanying drawings, wherein:
FIG. 1 is a perspective view of an RF and acoustical sealing system, in accordance with features of the present invention;
FIG. 2 is view of FIG. 1 taken along line 2-2;
FIG. 3 is a view of FIG. 1 taken along line 3-3;
FIG. 4 is a partial view of a manual sealing door in an open configuration, in accordance with features of the present invention. automatic sealing door within a jamb, in accordance with features of the present invention;
FIG. 5 is an exploded view of a door jamb, in accordance with features of the present invention
FIG. 6 is a cross sectional view of an automatic sealing system, in accordance with features of the present invention.
FIG. 7 is a perspective view of an automatic sealing system, in accordance with features of the present invention; and
FIG. 8 is a view of an automatic seal actuation mechanism, in accordance with features of the present invention.
FIG. 9 is a cutaway view of an automatic seal mechanism wherein a bladder actuates a seal between a jamb and a door, in accordance with features of the present invention.
FIG. 10 is a perspective view of a drop seal, in accordance with features of the present invention.
FIG. 11 is a view of FIG. 10 taken along line 11-11.
FIG. 12 is an elevated view of a drop seal in accordance with features of the invention.

### DETAILED DESCRIPTION OF THE INVENTION

The foregoing summary, as well as the following detailed description of certain embodiments of the present invention, will be better understood when read in conjunction with the appended drawings.

As used herein, an element or step recited in the singular and preceded with the word "a" or "an" should be understood as not excluding plural said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

The invented system provides a high performance architectural style door. The invented system incorporates RF shielding as well as radiation shielding for x-ray, gamma ray and other forms of hazardous radiation from nuclear generation sources. For example, the door of the system enables attenuation of a myriad of radiation types, and also is capable of acoustic attenuation. The step design of the door is particularly effective in providing acoustic attenuation.

The system is applicable as either a manually operated system, an automatically operated system, or a combination of these two modalities.

Specifically, the present invention provides a manual and an automatic system for creating an RF seal that allows easy ingress and egress to and from an RF shielded room. The system is applicable for all medical and nonmedical yet high-performance markets. For example, the present invention embodies a single-platform product for all medical doors such that the single platform can accommodate both manual or automatic door operation. A salient feature of the invention is a hollow jamb to accommodate the installation of additional electronics or acoustic material, even after site installation. Certain embodiments of the invention accommodate a plurality of bladder actuated seals, such as six bladders per door leaf.

Attenuations of approximately 100 dB up to 6 GHz are enabled by the incorporation of multiple surfaces adapted to receive different types of seals. The seals can be combined in different configurations to provide varying degrees of performance depending on specific requirements of the application. Furthermore, the seals can be comprised of different materials and profiles to further enhance shielding performance.

A first embodiment of the invention is a low-cost, entry level manual door. However, this first embodiment can be enhanced to define subsequent embodiments having full automatic functionality and the ability to be tailored to specific acoustical and RF attenuation needs. RF shielding performance will be a minimum of 106 dB at 150 MHz. The door allows greater than 100 dB at 500 MHz to accommodate higher-field MRI systems. However, performance to 3 GHz (and up to 6 GHz) with greater than 100 dB is desired for applications outside of the medical market. ("dB" is a logarithmic description comparing a beginning number [the "reference level"] to a final shielded number [the "received number"] inside the room. A spectrum analyzer is generally used to measure the RF signal strength in dB. When both the reference level and the received signal are measured in dB, the final attenuation (shielding effectiveness of the RF room) is found by simply subtracting the received signal from the reference level. 100 dB represents a 99.999% effectiveness in the reduction of the RF signal of concern. Generally, the higher the frequency, the harder it is to achieve this level of shielding effectiveness.)

Target acoustic performance parameters (e.g., sound transmission class (STC) ratings) for the invented system include the following:

| Door Type | STC |
|---|---|
| Base manual door | Between 20 and 25 |
| Base manual door with acoustic package | Approx. 34 |
| Base automatic door | Approx. 30 |
| Base automatic door with acoustic package | Approx. 40 |
| Base automatic door with enhanced acoustic pkg. | Approx. 45 |

Notwithstanding the foregoing, the invented system is envisioned to approach an STC of 50.

A salient feature of the present invention is a reveal extending substantially around the entire door frame or door jamb. This reveal allows for augmentation of RF sealing or STC rating as needed. The reveal was designed specifically to accommodate a variety of RF and acoustic seals, allowing a "mix and match" ability with seals to tailor the performance of the door to the specific customer requirements.

Features of an automatic RF door activation embodiment include the following:
Simplified RF sealing mechanisms;
Pneumatically driven;
Single DC servo motor that activates drive shafts with tension cams;
Failsafe seal release system activated by a door latch.
General features of the invented system include the following:

A threshold to conceal or otherwise physically isolate exposed hardware from the confines of the MRI enclosure, or from areas outside of the enclosure. The threshold is designed to be leveled and installed without removing the door. With no exposed fasteners, the door is much more compatible with operating room requirements for the elimination of "catch points" for liquids and dirt.

Door and jamb would feature reversible legs and doors for easy reconfiguration.

The invented door utilizes all mechanical construction such that welding is avoided. This avoidance of welding eliminates additional fabrication steps and therefore increases system integration reliability and reproducibility. Lower fabrication costs is the result.

Double door configurations allow flexibilities to the dimensions of inactive leaves that architects may call for in, but not limited to, 12 inch (30 cm) increments.

Provided in a standard 4 foot (122 cm) door leaf blank, instead of just a 48 inch (122 cm) clear opening. However, the width can be adjusted as needed, utilizing commercially available construction materials such as laminates. These materials come in standard widths such that custom fabrication/modification is not required.

Symmetrical hinges and door handle, such that the door can be swapped/reversed to accommodate right or left hand opening configurations.

Double door with removable, fixed center astragal.

A mag-lock system can be used on automatic doors to allow automated latching and unlatching as needed. An electric strike can also be used for automated latching and unlatching, as needed. Locking pins are used on manual versions of double doors to secure one or both door leaves to prevent unintended opening and/or compromising of the RF integrity of the shielded room.

Opening force of the door should approach zero. Closing force should be as low as possible but not greater than 10 pounds (44 N). A target force is 5 pounds (22 N).

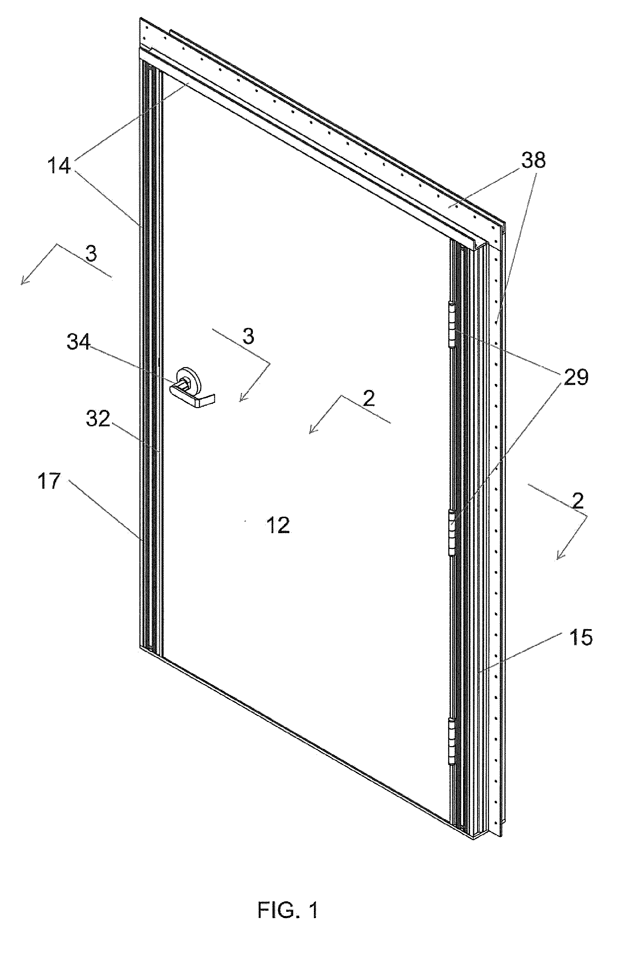

FIG. 1 is a perspective view of the invented RF and acoustic sealing system, designated generally as numeral 10. Generally, the system 10 comprises a door 12 and a jamb 14. FIG. 1 depicts the door 12 fully nested within the jamb 14. A salient feature of the jamb is the incorporation of horizontally and vertically disposed mounting flanges 38. The flanges are generally coplanar to the plane defined by the door 12, and extend beyond the periphery formed by the door jamb 14. The flanges 38 allow the system to be installed from the interior side of an MRI enclosure, no matter if the door is swinging in or out of the enclosure. The flange has been designed to be approximately in the center of the jamb so that the door can be rotated 180 degrees and have approximately the same amount of the jamb protruding outside the room regardless of which way the door swings.

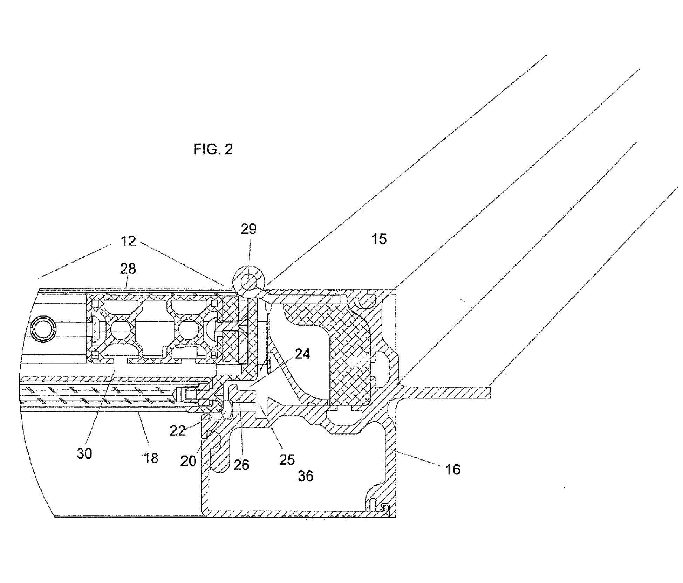

A feature of the invented configuration is that it defines a plurality of seal support surfaces such that each surface is adapted to receive additional sealing means. FIG. 2 depicts these support surfaces. For example, in an embodiment of the jamb 14 of the system, a continuous electrically conductive substrate 16 defines a plurality of niches to receive RF sealing material, acoustic material, electronics, and other miniaturized componentry. The continuous substrate 16 may be extruded, or machined.

### Door Configuration

### Detail

The inventors have found that a thicker door (e.g. between about 2 inches and 3 inches [about 5 cm and 7.6 cm], and preferably about 2.5 inches [about 6.4 cm]) allows for greater variability of the actual core construction as it relates to acoustic attenuation.

The thicker door design provides a means for enhancing acoustic shielding performance. Such performance requires the larger amount of mass confered by the thicker doors. Also, the thicker doors allow for use of less expensive wood cores, combined in different configurations, with and without fluid gaps, to "tune" the sound frequency shielding response of the door system. The added thickness also allows for a greater variation of material layers, and each change in layer material adds another "acoustic impedance" interface that further increases acoustic shielding performance. The variability of the interior components can also aid in tuning the weight of the door.

FIG. 2 depicts the door 12 of the system in a closed position with a proximal vertically extending portion 15 of a door jamb 14. A first planar surface 18 of the door 12 contacts an acoustic gasket 20, the later confined to a first seal support surface 22. The support surface 22 shown in FIG. 2 is configured as a pocket or cavity having a cross section complementary to the cross section of the gasket 20. In an embodiment of the system, the pocket is configured to frictionally engage the gasket 20 while allowing a portion of the gasket to protrude from support surface and establish physical contact with the door surface 18. As depicted in FIG. 2, the gasket 20 is reversibly deformed along its longitudinal axis when the door is swung into a fully nested position within the door jamb. This deformation provides additional means for assuring intimate electrical contact between the door 12 and the jamb 14. As such, the gasket 20 is adapted to move, reversibly mold to, or otherwise adjust to the surfaces of the jamb and the door during sealing operations.

FIG. 2 further depicts a second seal support surface 24 adapted to receive a similar gasket (e.g. an acoustic gasket) or a dissimilar one (such as a gasket for RF attenuation). This second pocket shares a common wall 26 with the first seal pocket and is located in board (i.e., displaced in a medial direction) from the first pocket.

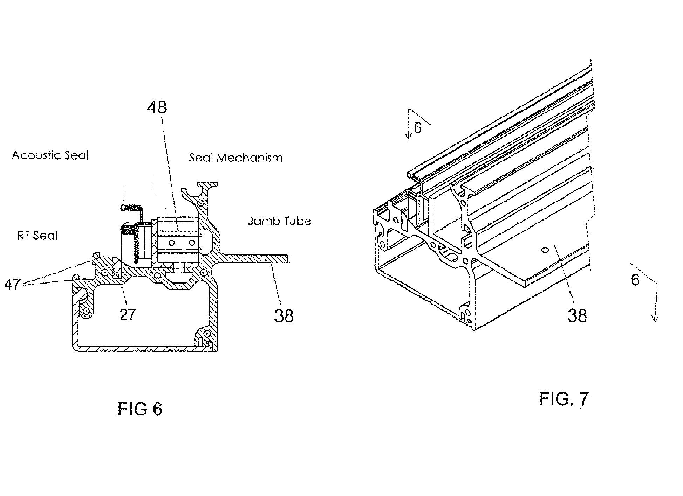

Using a longitudinal axis α of the door jamb as a reference point, the first pocket 22 is positioned more distal from the longitudinal axis than is the second pocket 24. As such, the common wall is positioned intermediate or between the first pocket and second pocket so as to be distal from the second pocket but positioned proximally to the first pocket. A channel 25 is positioned inferior and medially from the second surface 24, the channel adapted to receive a clamp 27 (seen in FIG. 6) for electrically connecting the automatic seal to the jamb.

The door leaf 12 further defines a second planar surface 28 which faces in a direction opposite the direction the first planar surface 18 face. While either the first or second planar surface can be in physical contact with a hinge 29, FIG. 2 shows the first planar surface 28 in closer spatial relationship with the hinge 29.

Intermediate (i.e., positioned between) the first and second planar surfaces of the door 12 is a cavity 30 adapted to receive additional attenuation material such as a lead sheet, for incorporating radiation shielding, or for acoustic material to enhance the acoustic shielding properties of the door. As such, the cavity extends substantially the entire width and length of the door and is configured so as to be coplanar with the first and second planar surfaces of the door 12. This cavity 30 is intended for radiation shielding material, such as lead, or magnetic shielding material, such as silicon steel, used to contain the high strength magnetic field generated by MRI magnets.

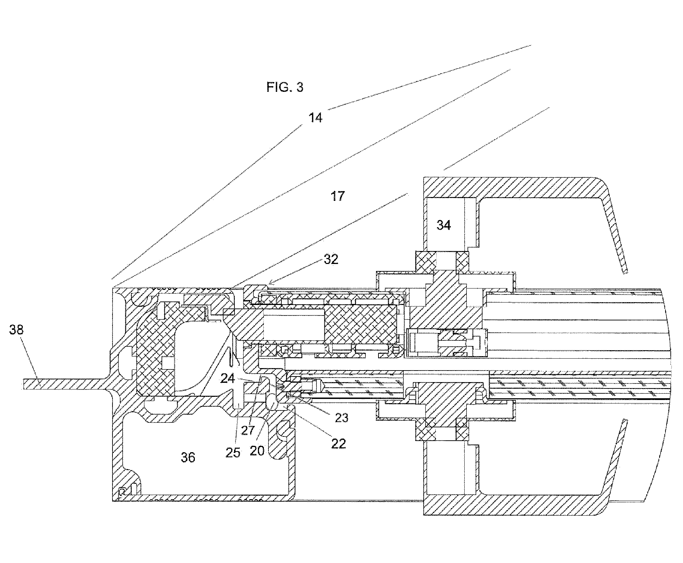

FIG. 3 is a view of FIG. 1 taken along line 3-3. FIG. 3 depicts a distal-most edge 32 of the door, which is to say the vertically disposed edge of the door in close spatial relationship to the handle 34. The distal edge 32 is depicted in closed position with the distal, vertically extending portion 17 of the door jamb. As with the configuration of the proximal, vertically extending portion of the jamb, the distal vertically extending portion 17 of the jamb features seal support surfaces 22, 24 adapted to receive a myriad of acoustic and or RF shields. These support surfaces also define sound attenuation chambers, as discussed below, when the leaf nests within the door jamb.

A salient feature of the invented door and door jamb is the stepped design which runs longitudinally along the edge of the jamb and which opposes the distal-most edge 32 of the door. The steps are labeled as 22 and 24 in this figure, with a laterally disposed first step 22 situated nearest to one exterior surface of the door so as to define a surface that partially opposes the exterior surface while also being generally flat and parallel with that exterior surface.

A second, step 24 is situated medially from the first step 22 so as to be positioned closer to the middle of the door jamb. As with the first step, this second step is generally flat so as to form a partially planar surface that is parallel with the exterior surfaces of the door. Directly opposing this partially planar surface is a laterally extending portion 27 of the distal-most edge 32 of the door that is cantilevered over the second step. A third surface 23 is positioned between the first step 22 and second step 24, such that the first surface is perpendicular to the planar surfaces formed by each of the steps. In an embodiment of the invention, the first step, second step 24 and third surface are integrally molded together.

It becomes readily apparent that, when the door engages the jamb at these points, sound cannot come straight through the void between the door and jamb, but must traverse a series of 90 degree turns to pass through the void area (e.g., the zigzag space) defined by the surfaces 22, 23, and 24 on the jamb opposed to complementary shaped surfaces on the surface of the distal-most edge of the door. This attenuates sound transmission through the door/jamb interface.

In summary of this point, the door leaf and the jamb form a plurality of sound attenuation chambers when the leaf is fully nested in the jamb. The plurality is defined by two parallel surfaces separated by an orthogonally disposed surface. Optionally, the chambers are adapted to receive reversibly deformable substrate.

The distal, vertically extending portion 17 of the jamb also defines a cavity 36 adapted to receive acoustic material, mechanical componentry, or electronic componentry, that cavity extending substantially vertically along the length of the extending portion 17 of the jamb. The cavity 36 is positioned laterally from the aforementioned seal support surfaces and enclosed by a conductive material. In an embodiment of the invention, the aforementioned jamb portions are machined, forged or otherwise extruded as a single piece such that the support surfaces and the cavities are integrally molded with each other. Alternatively, the various structures are removably attached to each other with electrically conductive fasteners so as to maintain the electrical conductivity of the jamb 14.

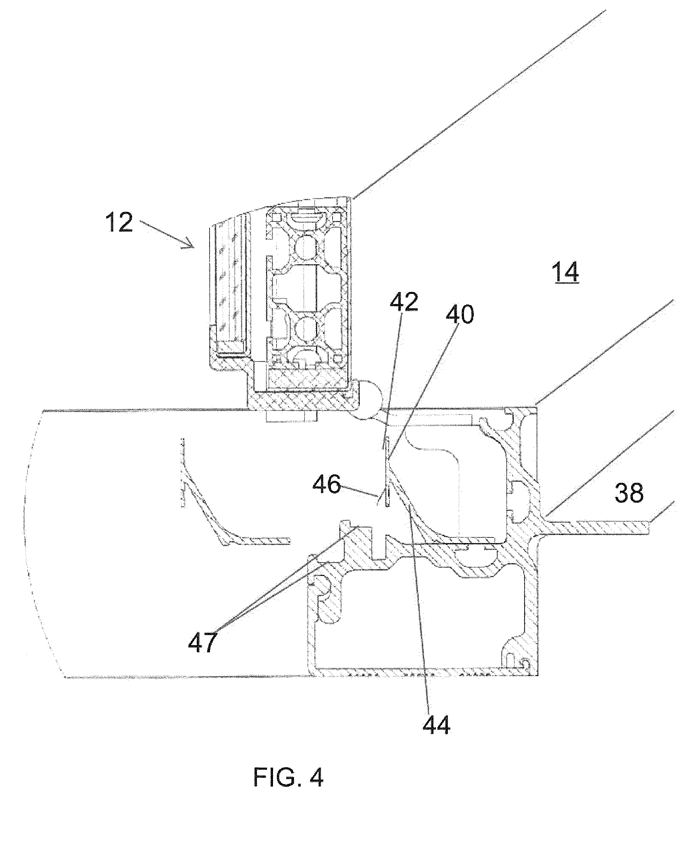

As depicted in FIG. 4, which is a partial view of an open door, 44 is a removable, adjustable seal carrier, molded with or otherwise attached to a surface 42 parallel to the vertical edge of the door when the door is closed. A reveal 40 is an extension of the seal carrier 44 such that the reveal and the carrier form a continuous surface. The reveal 40 is designed to provide a means to conceal the area behind 44, to provide a surface for activating the drop seals on a manual version of the door, and to provide the electrical contact surface for mounting the RF seal 46.

A plurality of vertically extending reveals 47 laterally positioned from the RF seal are provided. Generally, the reveals comprises a plurality of surfaces medially or laterally offset form each other and are generally flat. The surfaces defining the reveals can be generally perpendicular to each other. One of the surfaces faces inwardly to the space defining the door opening. This surface is adapted to contact and depress an actuator pin for a drop seal as the door is closed within the jamb.

Positioned medially from the reveal is an RF finger carrier 44, which is generally elongated in nature. The RF finger carrier is modular in that it is removably attached to the jamb. One elongated edge of the carrier supports finger stock 46, which frictionally engages the door when the door nests within the jamb. For the automatic version of this door, assembly 44 can be easily removed and replaced with the automatic mechanism used on the door.

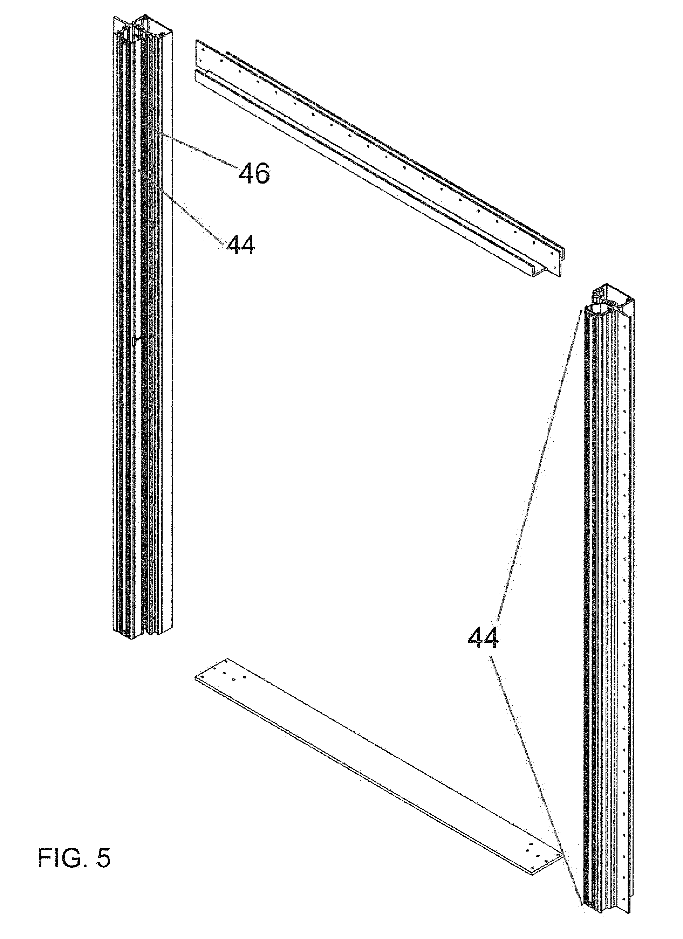

FIG. 5 provides an exploded view of the jamb, depicting the finger stock 46, and its carrier 44.

Another elongated edge of the carrier 44 is reversibly attached to the door jamb with clips, bolts or the like. This modularity of the carrier confers flexibility in terms of how the door is mounted within the jamb, and allows the door to be reversed so as to swing outward instead of inward, or to be mounted with its handle on the left side of the jamb (looking at the closed door from outside the enclosure) or the right side of the jamb. Also, an embodiment of the invention does not use RF spring contacts as the primary RF seal. Also, a retractable RF seal at the door bottom and top helps reduce or eliminate damage to the seal.

FIGS 6-8 depict detail related to an automatic door sealing system. FIG. 6 is a cross sectional view of FIG. 7, taken along line 6-6. As with the manual actuation system, this automated system features a plurality of RF- and acoustic-seals. As shown in FIG. 6, the two types of seals can be integrally molded to a single carrier so as to be actuated simultaneously.

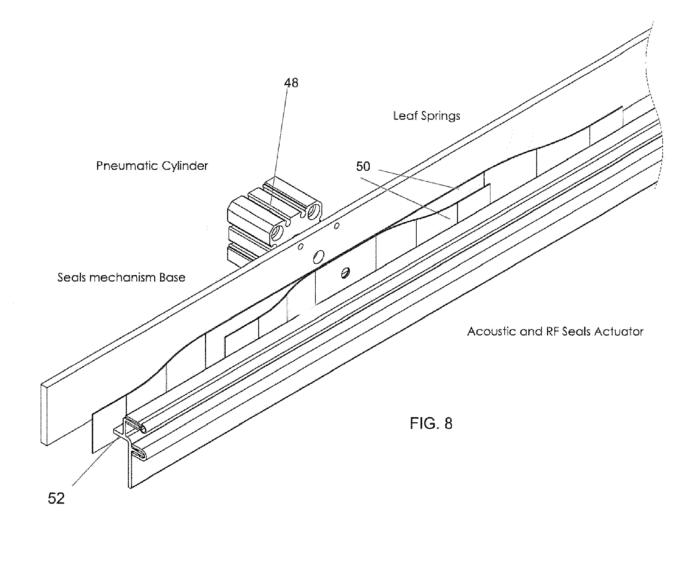

FIG. 8 is a detailed view of the actuation mechanism in automatic sealing systems featured in FIGS. 6 and 7. The actuation system comprises a pneumatic cylinder 48 acting upon the acoustic- and RF-seals via an intermediately positioned leaf spring or plurality of leaf springs 50. In an embodiment of the invention, the spring(s) are designed to default or bias to an unsealed configuration such that the seals are normally in an undeployed mode. In operation, the pneumatic cylinder provides an outward force to the leaf springs and therefore a seal-support surface such as a carrier 52.

A feature of this automatic actuation system is that the leaf spring, so positioned between the pneumatic cylinder and the seal carrier 52, confers an even force along the entire longitudinally extending surface of the carrier 52. This confers continuous, unbroken, intimate contact with surfaces opposing the terminal ends of the seals.

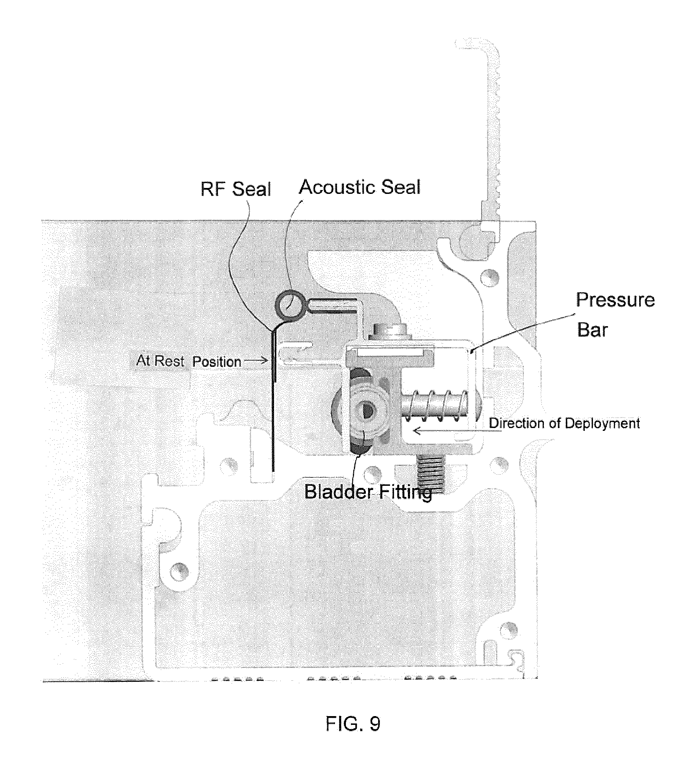

FIG. 9 is a cross sectional view of an automatic door seal actuation system whereby bladders are used to actuate the seals, be they acoustic, or RF, or radiation shields, or some or all of these seal types. The figure shows the seals fully deployed, as depicted by the arrows.

In a preferred embodiment, the invented system provides a high performance RF and acoustic shielding in one architecturally designed door. High performance means attaining at least an STC 45 acoustic rating and achieving at least 100 dB RF attenuation at 1 GHz, with the design intent to reach 100 dB at a minimum of 6 GHz, is possible. A plurality of seals that can be "mixed and matched" to achieve better RF and acoustic performance as needed by a user. The design lends itself to both increased RF and acoustic performance by the nature of the stepped configuration of the door. The use of RF finger stock is designed to minimize the required contact surface for achieving good RF performance, meaning there is less frictional force (on the manual door) experienced by a user. This new design minimizes the forces required to open and close a manual door.

The door has been designed to be modular so that a heavy door, such as a lead shielded door, can be shipped in sections and assembled in the field at the location where it is to be installed. This single-design platform can accommodate both a manual door and an automatic sealing door that eliminates opening and closing friction. An automatic sealing door also allows for the use of automatic opener/closers and other motion control features for more control in the event of a fire or for infection control.

The door is designed to always be mounted from inside the shielded room, but it can be mounted as either in an inswing or outswing configuration.

### Drop Seal

### Detail

As discussed supra, the invented system incorporates a drop hinge feature, or a drop seal. A "drop hinge" has a cam action on the barrel of the hinge to physically raise the door when opening, and lowering the door when closing, thereby creating a seal at the bottom of the door by lowering the entire door closer to the threshold.

The "drop seal" feature is activated by pushing a bar or lever to actuate an elongated substrate in a direction orthogonal to the direction the bar or lever is pushed. As such, a drop seal is positioned proximal to and coplanar to the bottom and top edges of the door. It is noteworthy that the seals are mounted in opposite directions such that the drop seal at the bottom horizontally disposed edge of the door is mounted to enable its elongated substrate to extend outwardly pass the bottom of the door and down toward the threshold. Conversely, the drop seal mounted at the top vertically disposed edge of the door is mounted to enable its elongated substrate to extend outwardly past the top of the door and up toward the top of the jamb. A plurality of drop seals can be mounted at each of the top edge and or bottom edge of the door.

The drop seals raise and lower just as the door reaches the full closed position to allow for a more "automated" function on a manual door. The drop-seals are used beyond their intended use as smoke and sound seals to serve as means for creating RF seals at the top and bottom of the doors to help further reduce the amount of frictional forces required to open and close the door. Drop seals also allow the use of a flat threshold to aid in the passage of gurneys, wheel chairs, etc. and prevent potential trip points. (Important for these specialized RF doors.)

A myriad of drop seals are commercially available, including but not limited to the Pemko Seal (Pemko Inc., Memphis Tennessee), Zero International (New York, NY) and National Guard Products (Memphis, TN).

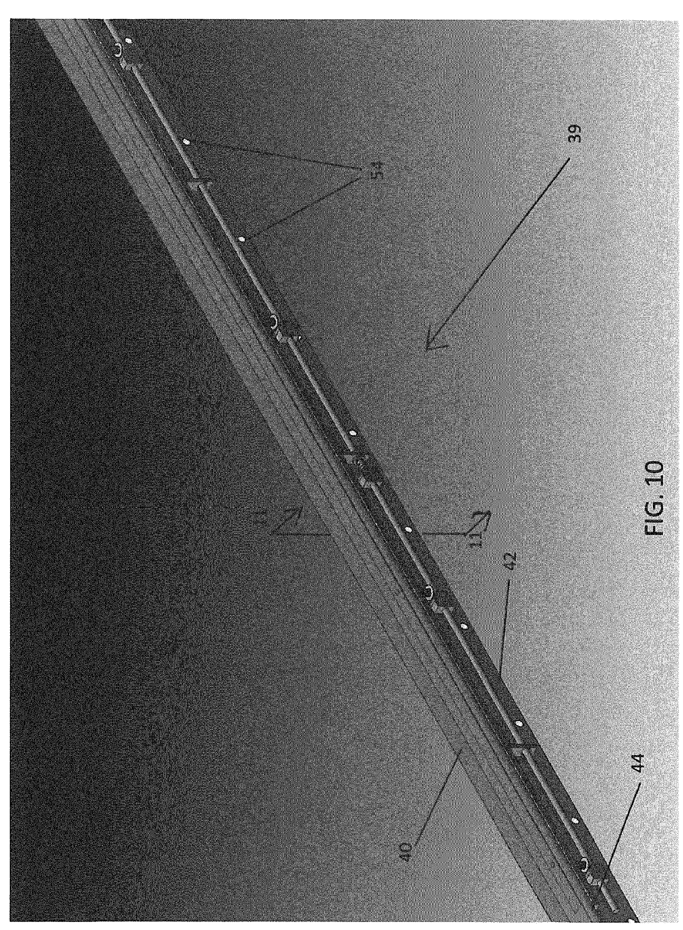

FIG. 10 is a perspective view of a drop seal assembly (designated as 39 developed by the inventors. It should be noted that while the drop seal depicted in FIG. 10 is adapted to be mounted to leaf edges, the design is adaptable for mounting within the door jambs.

As discussed supra, an elongated substrate 40 (e.g. the RF seal) is projected (upwardly if positioned as pictured) when a bar 42 or lever is extended in a direction orthogonal to the elongated substrate's direction of travel.

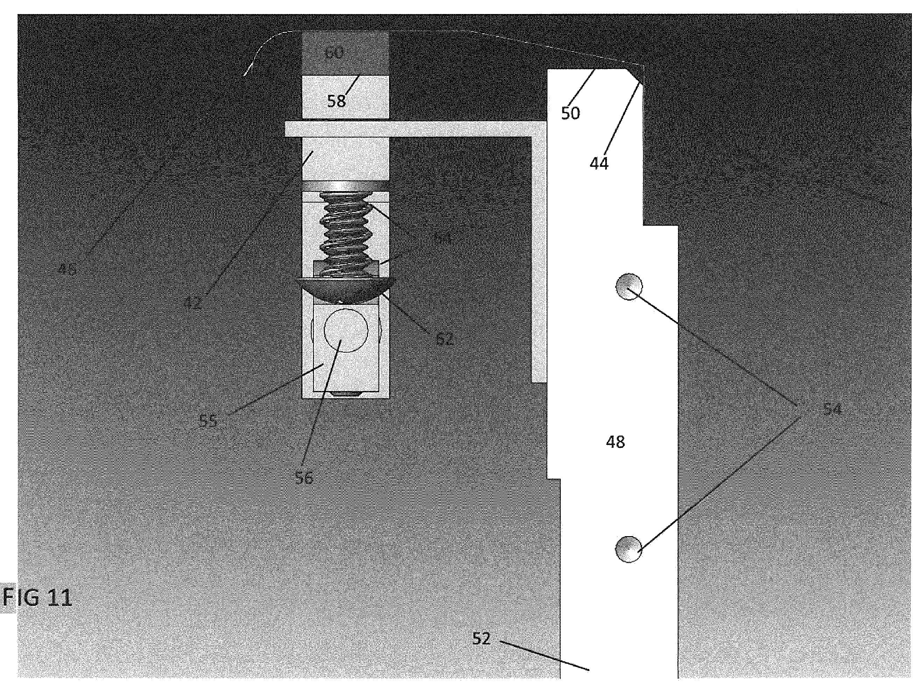

As depicted in FIG. 11, the elongated substrate 40 defines a first longitudinally extending proximal edge 44 and a second longitudinally extending distal edge 46, the distal edge cantilevered over the actuating bar 42.

The entire assembly is supported by a bracket 48 defining a first upwardly facing end 50 and a second depending end 52. As pictured, the first end is adapted to receive the proximal edge 44 of the elongated substrate. The proximal edge may be permanently or reversibly attached to the first end of the bracket.

Proximal to the depending end of the bracket may be a series of apertures 54 or other attachment means to facilitate installation to new or existing MRI doors.

In operation, actuation of the elongated substrate 40 occurs when a bar 56 engages a cam 55, or plurality of cams, such that the cams, so engaged, deploy screws 62 upwardly against a depending end of the actuating bar 42. In an embodiment of the invention, a first end of the bar 56 extends beyond the door edge so as to be forced in a medial direction (i.e., toward the midline of the door) upon the first end of the bar 56 contacting a portion of the door jamb when the door is closed and fully nested within the jamb.

Upon opening of the door, a spring 64 circumscribing each of the screws biases the screw(s) downwardly so as to de-deploy or retract the RF seal (elongated substrate 40) toward the edge of the door and away from the jamb.

The actuating arm 42 defines a first upwardly facing end 58 which is positioned proximal to an underside surface of the elongated substrate 40. It is this end that moves the substrate in an upwardly direction once such a call or signal is so received by the piston actuator 56. Optionally, reversibly deformable substrate 60 is positioned between the underside surface of the elongated substrate 40 and the upwardly facing end 58 of the actuating bar 42. This deformable substrate confers a means for fine tune adjustment of the elongated substrate.

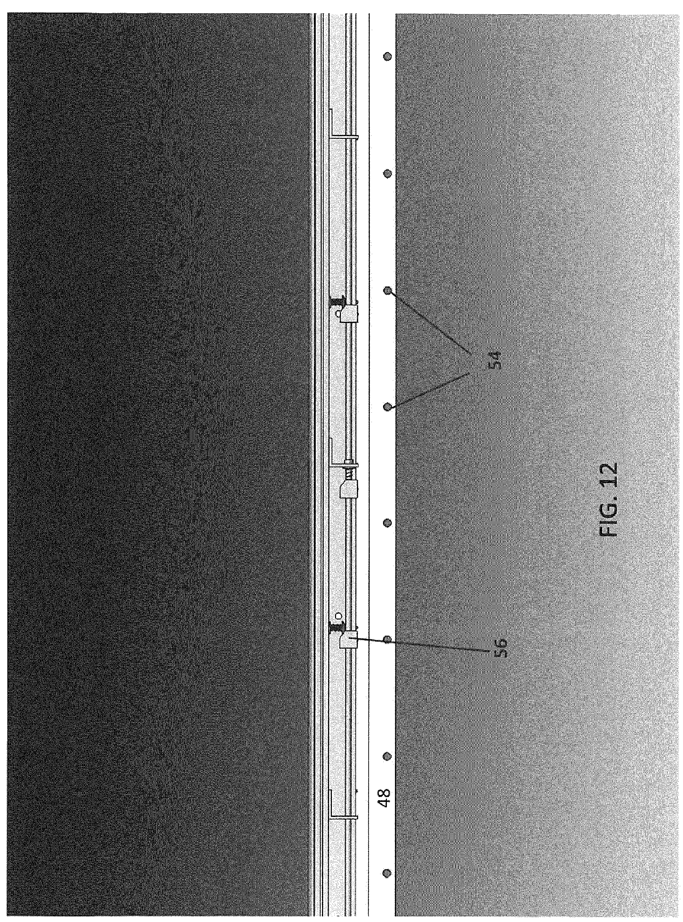

FIG. 12 is a side view of a drop seal assembly, depicting its various elements, discussed supra.

In light of the foregoing, it becomes apparent that the RF seal is deployed when the leaf contacts the jamb. The seal is biased to an undeployed configuration when the leaf is not nested within the jamb. Furthermore the seal operates without electrical power. A plurality of seals are actuated simultaneously along different edges of the leaf when the leaf is nested within the jamb. Also, the seal actuates simultaneously with the formation of the sound attenuation chambers. The seal actuation and the formation of the sound attenuation chambers occurs without electrical power. Conversely, the seal deactivates at the same time that the sound attenuation chambers dissociate. Further, the system as recited in claim 10 wherein the seal deactivation and the chamber dissociation occurs when the leaf is decoupled from the jamb.

It is to be understood that the above description is intended to be illustrative, and not restrictive. For example, the above-described embodiments (and/or aspects thereof) may be used in combination with each other. In addition, many modifications may be made to adapt a particular situation or material to the teachings of the invention without departing from its scope. The base design is configured in such a way that the seal mechanism, as a separate design entity, can be configured in multiple configurations for manual or automatic use, and then mated to the base design. While the dimensions and types of materials described herein are intended to define the parameters of the invention, they are by no means limiting, but are instead exemplary embodiments. Many other embodiments will be apparent to those of skill in the art upon reviewing the above description. The scope of the invention should, therefore, be determined with reference to the appended claims, along with the full scope of equivalents to which such claims are entitled. In the appended claims, the terms "including" and "in which" are used as the plain-English equivalents of the terms "comprising" and "wherein." Moreover, in the following claims, the terms "first," "second," and "third," are used merely as labels, and are not intended to impose numerical requirements on their objects.

As will be understood by one skilled in the art, for any and all purposes, particularly in terms of providing a written description, all ranges disclosed herein also encompass any and all possible subranges and combinations of subranges thereof. Any listed range can be easily recognized as sufficiently describing and enabling the same range being broken down into at least equal halves, thirds, quarters, fifths, tenths, etc. As a non-limiting example, each range discussed herein can be readily broken down into a lower third, middle third and upper third, etc. As will also be understood by one skilled in the art all language such as "up to," "at least," "greater than," "less than," "more than" and the like include the number recited and refer to ranges which can be subsequently broken down into subranges as discussed above. In the same manner, all ratios disclosed herein also include all subratios falling within the broader ratio.

One skilled in the art will also readily recognize that where members are grouped together in a common manner, such as in a Markush group, the present invention encompasses not only the entire group listed as a whole, but each member of the group individually and all possible subgroups of the main group. Accordingly, for all purposes, the present invention encompasses not only the main group, but also the main group absent one or more of the group members. The present invention also envisages the explicit exclusion of one or more of any of the group members in the claimed invention.

## Claims

1. A modular system (10) to attenuate radio frequency encroachment and acoustic noise into an enclosure, the system comprising:
a door leaf (12);
a jamb (14) adapted to receive the door leaf (12); and
a plurality of acoustic and RF seals (20, 46) removably positioned on the jamb, or
on the door leaf, or both;
wherein the jamb (14) is adapted to receive a plurality of radio frequency, radiation, and acoustic attenuation seals.

2. A system (10) according to claim 1, wherein the seals are actuated as the door leaf (12) is received in the jamb (14).

3. A system (10) according to claim 1 or claim 2, wherein the door leaf (12) is in rotatable communication with the jamb (14) such that it can swing into or out of the enclosure, or in slidable communication with the jamb.

4. A system (10) according to any preceding claim, wherein the jamb (14) comprises an elongated substrate (40) to support a seal or plurality of seals, and whereby the elongated substrate (40) is removably attached to an enclosure opening.

5. A system (10) according to claim 4, wherein the elongated substrate is specific for an automatic seal mechanism or a manual seal mechanism.

6. A system (10) according to any preceding claim, wherein the door leaf (12) and the jamb (14) form a plurality of sound attenuation chambers when the door leaf is fully nested in the jamb.

7. A system (10) according to claim 6, wherein the plurality of sound attenuation chambers is defined by two parallel surfaces separated by an orthogonally disposed surface.

8. A system (10) according to claim 6 or claim 7, wherein the sound attenuation chambers are adapted to receive reversibly deformable substrate.

9. A system (10) according to any of claims 6 to 8, wherein the seal is actuated simultaneously with the formation of the sound attenuation chambers, optionally wherein the seal actuation and the formation of the sound attenuation chambers occurs without electrical power.

10. A system (10) according to any of claims 6 to 9, wherein the seal deactivates at the same time that the sound attenuation chambers dissociate, optionally wherein the seal deactivation and the chamber dissociation occurs when the door leaf (12) is decoupled from the jamb (14).

11. A system (10) according to any preceding claim, wherein the seal is positioned on the door leaf (12).

12. A system (10) according to claim 11, wherein the seal is deployed when the door leaf (12) contacts the jamb (14).

13. A system (10) according to claim 11 or claim 12, wherein the seal is biased to an undeployed configuration when the door leaf (12) is not nested within the jamb (14).

14. A system (10) according to any preceding claim, wherein the seal operates without electrical power.

15. A system (10) according to any preceding claim, wherein a plurality of seals are actuated simultaneously along different edges of the door leaf (12) when the door leaf (12) is nested within the jamb (14).
